# EUROPEAN PATENT APPLICATION

(11) **EP 4 815 644 A1**
(43) Date of publication of application: **30.09.2026**
(21) Application number: 25167224.2
(22) Date of filing: 28.03.2025
(51) Int. Cl.: H05K 1/18, H05K 3/10, H01L 23/538, H01L 23/00, H05K 3/46, H01L 23/14, H05K 1/03, H05K 3/00, H05K 3/12, H05K 3/40

(54) **COMPONENT CARRIER WITH BRIDGE ELEMENT, AND MANUFACTURE METHOD**

(71) Applicant: AT & S Austria Technologie & Systemtechnik Aktiengesellschaft, 8700 Leoben-Hinterberg (AT)
(72) Inventor: GROBER, Gernot, 8741 Weißkirchen (AT); DONATELLO, Daniele, 8700 Leoben (AT); LEITGEB, Markus, 8793 Trofaiach (AT)
(74) Representative: Dilg, Haeusler, Schindelmann Patentanwaltsgesellschaft mbH

(57) **Abstract**

There is described a component carrier (100) comprising:
i) a stack (101), comprising at least one electrically insulating layer structure (102) and at least one electrically conductive layer structure (104);
ii) a bridge element (150) configured for connecting at least two components (110, 111) one to each other, wherein the bridge element (150) comprises:
a) at least one layer structure (151) made of organic dielectric material, and
b) at least one conductive wiring structure (160) extending along a bridging direction,
c) wherein, along a cross-section perpendicular to the bridging direction, the at least one conductive wiring structure (160) comprises at least two lateral walls (165, 166), both inclined with respect to the stack thickness direction.

## Description

### Field of the Invention

The invention relates to a component carrier comprising a stack with at least one electrically insulating layer structure and at least one electrically conductive layer structure, and a bridge element configured for connecting at least two components one to each other, wherein the bridge element comprises at least one layer structure made of organic dielectric material, and at least one conductive wiring structure extending along a bridging direction, wherein, along a cross-section perpendicular to the bridging direction, the at least one conductive wiring structure comprises at least two lateral walls, both inclined with respect to the stack thickness direction. The invention further relates to a method of manufacturing said component carrier.

Accordingly, the invention may relate to the technical field of component carriers, such as printed circuit boards or IC substrates, and their manufacture.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. At the same time, component carriers shall be mechanically robust and electrically and magnetically reliable so as to be operable even under harsh conditions.

There may be a trend in the component carrier industry to mount two or more electronic components onto a circuit board, whereby these electronic components are interconnected through an electric connection, in particular wherein the electric connection is embedded in the circuit board. In other words, instead of connecting the electronic components via traces on the circuit board, the electric connection between the electronic components is embedded into the circuit board and thus allows a much higher density of connections. Such an embedded interconnection may be termed a bridge and is generally provided by copper traces encapsulated in a silicon material.

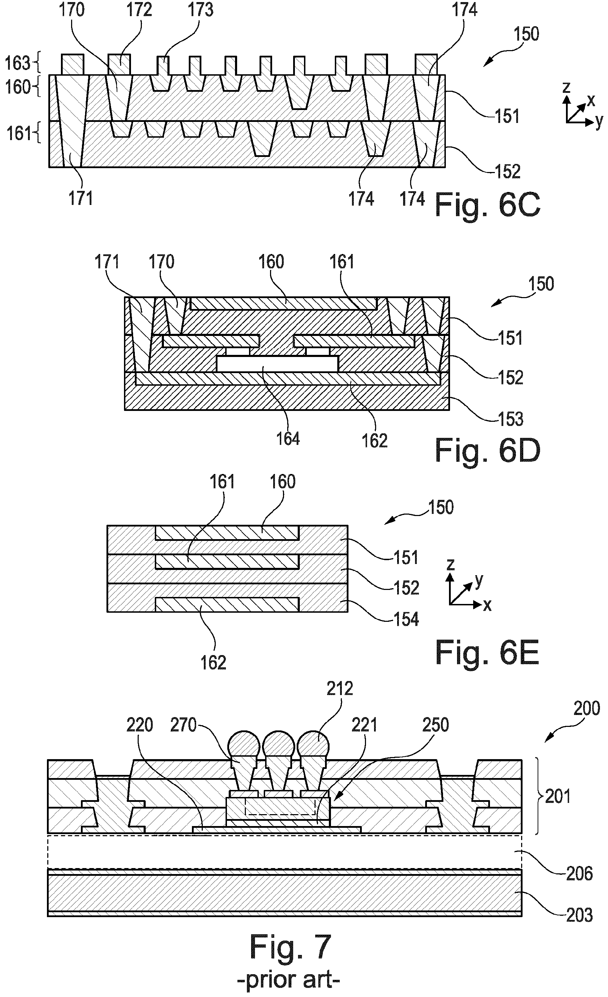

**Figure 7** shows an example of a conventional circuit board 200 with a stack 201 of electrically insulating layer structures and electrically conductive layer structures arranged on a core layer 203 and a further layer build-up 206. A bridge 250, made of silicon material, is embedded in the stack 201 and placed on an adhesive film 221 on top of a base layer 220. The upper main surface of the embedded bridge 250 is connected (by pads of the bridge 250) through vias 270 to the external upper main surface of the stack 201. Here, the exposed vias 270 are further connected to solder balls 212 that can in turn be further connected to the components (that are to be interconnected). As described above, the embedded bridge 250 can then interconnect two or more components that are surface-mounted to the circuit board 200. It is schematically illustrated that the electrically conductive interconnection in the bridge 250 is arranged in a "U"-like shape.

### Summary of the Invention

There may be a need to provide a component carrier with an efficient bridging functionality ensuring a homogenous and therefore reliable material composition and a cost effective solution.

According to an exemplary embodiment of the invention, a component carrier, a component carrier arrangement, and a method of manufacturing are described.

According to an aspect of the invention, there is described a component carrier (e.g. a printed circuit board, an IC substrate, an organic interposer, etc.) comprising:
i) a stack, comprising at least one electrically insulating layer structure and at least one electrically conductive layer structure, and
ii) a bridge element configured for connecting at least two components (in particular surface-mounted to the stack/component carrier) one to each other.

The bridge element comprises at least one layer structure made of organic (in particular silicon-free) dielectric (in particular electrically insulating) material, and at least one conductive wiring structure (e.g. a copper layer/foil/structure) extending along a bridging direction.

In particular, along a cross-section perpendicular to the bridging direction, the at least one conductive wiring structure comprises at least two lateral walls, both inclined with respect to the stack thickness direction (in particular being a footprint of a specific manufacture process, e.g. a nano imprint lithography, NIL, process, a reactive ion etching, RIE, process, or a (laser) trench process).

According to a further aspect of the invention, there is described a component carrier arrangement, comprising:
i) a component carrier as described above; and
ii) the at least two components assembled to the component carrier.

Hereby, the bridge element may (inter-) connect the at least two components one to each other.

According to a further aspect of the invention, there is described a method of manufacturing a component carrier (e.g. as described above), the method comprising:
i) providing a stack, comprising at least one electrically insulating layer structure and at least one electrically conductive layer structure;
ii) providing a bridge element,
iia) wherein the bridge element is for connecting at least two components one to each other,
iib) wherein the bridge element comprises at least one layer structure made of organic dielectric material, and at least one conductive wiring structure extending along a bridging direction, and
iic) wherein, along a cross-section perpendicular to the bridging direction, the at least one conductive wiring structure comprises at least one lateral wall inclined with respect to the stack thickness direction; and
iii) assembling (in particular embedding) the bridge element to the stack.

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board (PCB), an organic interposer, and an integrated circuit (IC) substrate. A component carrier may also be a hybrid board combining different ones of the above-mentioned types of component carriers.

In the context of the present document, the term "stack" may particularly denote a flat or planar sheet-like body. For instance, the stack may be a layer stack, in particular a laminated or rolled layer stack. Such a laminate may be formed by connecting a plurality of layer structures by the application of mechanical pressure and/or heat. Preferably, the plurality of layer structures are aligned parallel on top of each other. The stack may comprise electrically conductive layer structures and at least one electrically insulating layer structure. In an embodiment, the electrically conductive layer structures of the stack may have a line/space of more than 5 µm; in case of an IC substrate in particular between 8 µm and 25 µm, and in case of a PCB between 20 µm and 100 µm, in particular between 20 µm and 50 µm.

In the context of the present document, the term "layer structure" may particularly denote a continuous layer, a patterned layer or a plurality of nonconsecutive islands (discontinuous) within a common plane, and it may perform the function of electrical conductivity and/or electrical insulation. A layer structure may also comprise an interconnection structure which protrudes from a planar surface of the layer structure.

In the context of the present document, the term "main surface" may particularly denote a surface that is oriented along a plane in parallel to the directions of main extension (planar extension, horizontal plane, x-y) and perpendicular to a thickness direction (vertical direction, z). In an embodiment, an element/stack/carrier may comprise two directions of main extension (length, width) in the horizontal direction and a perpendicular extension (which is not a main extension) in the vertical direction (thickness). In an embodiment, such a main surface of the stack/component carrier may be the external surface. For example, a first main surface may be the upper external surface and a second main surface may be the (opposed) lower external surface.

In the context of the present document, the term "bridge element" may in particular refer to any discrete element, in particular discrete component, that may function as an electric interconnection between (active/passive) components, in particular electric/electronic components. In an example, the bridge element may require at least two (exposed) electrically conductive terminals to connect respectively to the components. In a more sophisticated example, the bridge element may comprise a plurality of terminals for (inter-)connecting two or more components. The electrically conductive terminals (preferably these terminals are exposed at the same main surface (top main surface) of the bridge element) may be interconnected by an electrical interconnection arranged in the bridge element. In a preferred embodiment, said electrical interconnection may be realized by a conductive wiring structure. In an embodiment, said conductive wiring structure may be provided as a layer structure. Yet, in an embodiment, the bridge element may comprise two or more stacked layers, so that respective conductive wiring structures may be combined with respective (metal filled) vias to a "U"-shape (or a "Y"-shape or a " 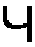 " shape). The bridge element may include further structures with functionalities beyond the interconnection between components, for example resistance measurements, ground, thermal dissipation, etc.

In the context of the present document, the term "organic dielectric material" may in particular refer to a material suitable for forming a layer structure of a bridge element, e.g. to at least partially embed (protect) the conductive wiring structure and/or to support said conductive wiring structure. The organic dielectric protection material may be the same or different compared to dielectric material of the component carrier stack (for example (reinforced) resin material), in which the bridge element is associated, in particular (partially) embedded. In a preferred embodiment, the organic dielectric material may consist of or comprise an organic material, for example a resin (e.g. ABF or PID) material. In this example, the organic dielectric material may not comprise silicon (essentially free of silicon) and/or may comprise fillers; in the last case, as organic dielectric material it may be meant the material of the binder, for example the resin wherein the fillers are provided, eventually even having embedded inorganic fillers therein. In an example, the organic dielectric material may be free of an inorganic material, in particular metal and/or ceramics. In an embodiment, the term "dielectric" may refer to an electrically insulating property. In a further embodiment, the term "dielectric" may refer to a material with a dielectric constant of at least 2. Additionally or alternatively, the organic dielectric material may have an electrically resistivity higher than 10⁸ Ω × m. Preferably, the organic dielectric material may comprise polymeric material, for example epoxy resin and/or poly(meth)acrylate.

In the context of the present application, the term "associated" may mean that two things are related with another, in particular connected to another or in contact with each other.

In the context of the present document, the term "conductive wiring structure" may in particular refer to an electrically/thermally conductive (layer) structure suitable for providing a conductive functionality to a bridge element. In an embodiment, the conductive wiring structure may be at least partially embedded in (a main surface of) an organic dielectric material layer structure (as described above). Alternatively, the conductive wiring structure may be provided on a main surface of the organic dielectric material layer structure. In an embodiment, the conductive wiring structure may comprise a metal, e.g. copper. In another embodiment, the conductive wiring structure may be configured as a metal trace. In an embodiment, the conductive wiring structure comprises a bottom portion (and a lower main surface) and an upper portion (and an upper main surface). In an embodiment, these portions may be connected by (two) lateral walls (sidewalls). In a preferred embodiment, these lateral walls are inclined (with respect to the thickness direction z of the stack), in particular being a footprint of a specific manufacture process. Preferably, the conductive wiring structure may comprise metal applied by a galvanic plating process and/or by an electro-less process. Additionally or alternatively, the conductive wiring structure may comprise metal created by chemical vapor deposition and/or physical vapor deposition. In an embodiment, the wiring structure may have a line/space of 0.5 µm to 5 µm, in particular from 0.5 µm to 3 µm.

In the context of the present document, the term "bridging direction" may in particular refer to an ideal (virtual) main direction to connect the two portions (electrodes, pads, terminals, etc.) of the two respective components that are actually connected one to each other by the conductive wiring structure of the bridge element. In an embodiment, the bridge element may be connected to two components with respective electric connections. Said electric connections may be connected by the conductive wiring structure in the bridge element, e.g. in form of a trace, in particular along a main direction. The direction of main extension (length) of said trace may be seen as corresponding to the bridging direction, in this example.

A "cross-section perpendicular to the bridging direction" may be understood as a (ideal/virtual) plane perpendicular to the above defined bridging direction. For example, in case that the conductive wiring structure is formed as a trace, the width and the height of the trace and/or the plane perpendicular to the main extension direction of the trace may be considered as defining/consisting of the (virtual) plane corresponding to the cross-section perpendicular to the bridging direction. In an embodiment, the extension of the conductive wiring structure in the bridging direction is larger than the extension of the conductive wiring structure perpendicular to the bridging direction.

According to an exemplary embodiment, the invention may be based on the idea that a component carrier with an efficient bridging functionality (interconnecting two or more components) can be provided, when a bridging element is assembled to the stack, which bridge element comprises at least one organic dielectric layer structure with at least one conductive wiring structure (in particular an embedded surface-exposed trace), wherein at least two lateral walls of said conductive wiring structure are inclined/slanted (with respect to the stack thickness direction). Said inclined lateral walls (seen in a cross-section perpendicular to the bridging direction) may be a footprint of a specific manufacture process (for example a nano imprint lithography process, a reactive ion etching process, a laser trench process etc.) that is especially suitable for forming miniaturized structures (very fine lines, fine line-spacing) in a highly precise manner, in particular in combination with organic dielectric material commonly used in component carriers such as PCB, IC substrates, interposer, consequently. Said organic dielectric material improves the overall reliability of the component carrier due to the homogeneity of the material minimizing a mismatch of physical properties (e.g. CTE, Young modulus, etc.) between the material of the bridge element and the material of the stack.

With the described approach, it may be possible to provide precisely fine line embedded conductive wiring structures (e.g. traces) in/on an organic dielectric layer structure. Since components to be interconnected, such as semiconductor elements, may comprise hundreds of electric pads, it may be crucial to provide a bridge element with a very high density of electric structures. It has been found by the inventors that such a high density may be provided by specifically manufactured conductive wiring structures in an organic dielectric material. The manufacture process of such a bridge element may be reflected by the above described inclined lateral walls of the at least one conductive wiring structure.

The described approach may enable a highly flexible and versatile architecture. For example, two or more layer structures (with respective conductive wiring structures) may be stacked. Vertical connections such as vias may enable connection of the lower layers to the components to be interconnected. Such a bridge element may be understood as a modular system that can be adapted/adjusted in an easy and straightforward manner to the desired application in a highly flexible manner.

Additionally or alternatively, embedding a bridge element comprising organic dielectric material may cause less issues compared to silicon comprises bridges from state of the art, since no foreign material (with respect to those used in a common component carrier) have to interact with the component carrier. The adhesion between the organic dielectric material of the bridge element and a material embedding the bridge element may be stronger than the adhesion between an embedding material and a silicon comprising bridge element.

### Exemplary Embodiments

In an embodiment, the at least one conductive wiring structure comprises at least two lateral walls, both inclined with respect to the stack thickness direction, along a cross-section parallel to the bridging direction.

In an embodiment, the at least one conductive wiring structure comprises a bottom portion and an upper portion connected by the (at least) two lateral walls. The bottom portion may be arranged at an embedded main surface of the conductive wiring structure, while the upper portion may be arranged at an exposed (with respect to the at least one layer structure) main surface (opposed to the lower main surface) of the bridge element. The lateral/side walls may extend in the vertical direction (thickness direction of stack/bridge) and are inclined with respect to said vertical direction. In an embodiment, the inclination of the two lateral walls is similar or different. In an embodiment, the inclination with respect to the thickness direction (when seen as a straight vertical line) may be in the range 0.5⁰ to 30⁰, in particular in the range from 0.5° to 15°.

According to an alternative embodiment of the present invention, the at least one conductive wiring structure comprises either a bottom portion or an upper portion, and the two lateral walls match one to each other due to their slanting directions, on the opposite side than the position of the bottom portion or the upper portion, preferably defining a rounded edge; this embodiment can be the footprint of the formation of the trench defining the wiring structure using a laser trenching process, in particular a laser ablation, resulting in a cross section of the wiring structure having said specific "triangle-like" shape.

In an embodiment, the at least two lateral walls define a slanted shape toward to or away from the at least one layer structure (and/or the conductive wiring structure). In an embodiment, the at least two lateral walls define a slanted shape towards the at least one layer structure in case there is an embedded conductive wiring structure. In an embodiment, the at least two lateral walls define a slanted shape away from the at least one layer structure in case there is an embedded conductive wiring structure on the main surface of the layer structure. In an embodiment, the two lateral walls may taper towards the inside (center) of the layer structure or away from (a center of) the layer structure. These structural features may be the footprint of a highly advantageous manufacture process (such as NIL, laser trench process, etc. e.g. being highly precise, enabling miniaturization, in particular fine pattern/line-spacing).

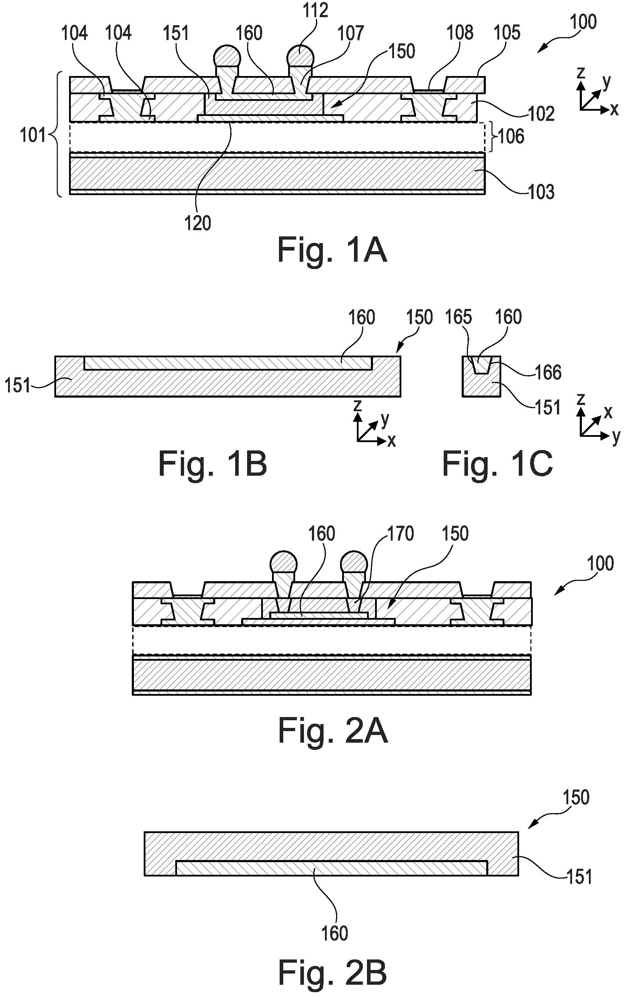

In an embodiment, the bridge element comprises at least one vertical connection (in particular a via or a pillar), extending from one main surface of the at least one layer structure to the at least one conductive wiring structure. Preferably, the via or pillar may be a metal comprising structure, and thus may transmit electric signal and/or electric current. This may provide the advantage that the embedded conductive wiring structure may be efficiently electrically connected, even though it may not be exposed at a bridge element outer surface. For example, the conductive wiring structure may be arranged at the main surface of the bridge element opposed to the respective main surface from where the at least one vertical connection extends (compare Figure 2A) and oriented towards the interior of the at least one layer structure. In another example, the conductive wiring structure may be covered by a further layer structure of the bridge element. In these cases, a re-routing or unbundling of the conductive wiring structure and thus efficient, reliable connections may be provided (in a design-flexible manner) by one or more vertical connections that extend through one of more layer structures of the bridge element.

In an embodiment, the component carrier further comprises a via associated to the at least one conductive wiring structure. In an embodiment, the component carrier further comprises a pillar associated to the at least one conductive wiring structure. In an embodiment, the via/pillar (vertically) extends outside the at least one layer structure and/or the bridge element (compare Figure 6C). This may provide the advantage that efficient electric connection of the conductive wiring structure is enabled in a design-flexible manner. For example, the via/pillar may extend from the upper main surface of the bridge element away from the bridge element. In an embodiment, such a via/pillar may be a portion/trace of a surface conductive wiring structure on the surface of the bridge element. Such a via/pillar may be embedded together with the bridge element in the stack (material).

In an embodiment, the bridge element comprises a plurality of layer structures (stacked on top of each other). In an embodiment, at least two, more in particular all, (stacked) layer structures are made of (the same or different) organic dielectric material. This may provide the advantage that the bridge element may be designed and realized in a highly flexible manner, enabling a large variety of applications and adaptations to specific requirements and improving the overall reliability of the component carrier due to the homogenous material minimizing a mismatch of physical properties (e.g. CTE, Young modulus, etc.) between the material of the bridge element and the material of the stack. Each layer structure may be designed with a different connection functionality. When a plurality of electric contacts of components have to be connected, a plurality of layer structures may enable the provision of respective connections in a highly efficient manner. The layer structures (with respective conductive wiring structures) may be seen as a modular system can be assembled to exactly meet specific requirements.

In an embodiment, at least two of the plurality of layers (each) comprise at least one respective conductive wiring structure extending along the bridging direction. In an embodiment, at least one of those conductive wiring structures can be inclined (e.g. in the x-y plane corresponding/parallel to the main surface of the bridge/layer structures) in comparison to one other conductive wiring structure(s). In an embodiment, at least two of the conductive wiring structures are stacked parallel in the stacking direction. In an embodiment, the bridging directions of the at least two layer structures, in particular of the two adjacent layers, are parallel one to each other, in particular overlapping one to each other, along the planar view. Thereby, a uniform build-up, using a common manufacture process of the layer structures, may be applied. Additionally or alternatively, a high density of conductive wiring structures may be realized.

In an embodiment, in the cross-section perpendicular to the bridging direction, the at least one (in particular all) respective conductive wiring structure (in particular each conductive wiring structure) comprises at least two lateral walls, both inclined with respect to the stack thickness direction. Such a structural feature may help to create small conductive wiring structures and/or may help to increase the density of the conductive wiring structures inside the bridge element.

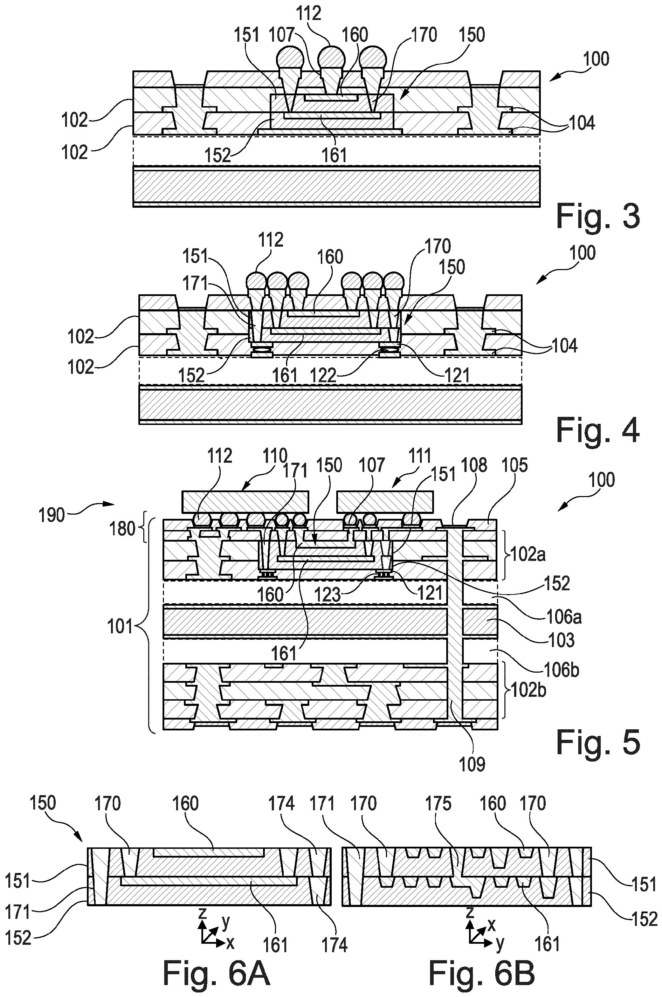

In an embodiment, the component carrier further comprises at least one vertical wiring connection connecting two conductive wiring structures of two adjacent, in particular stacked, layer structures (compare for example Figure 6B and Figure 6C). Such a (vertical) interconnection between two or more conductive wiring structure may enable a high functional flexibility regarding electrical interconnection. In an embodiment, the vertical wiring connection is realized by a portion/trace of the upper conductive wiring structure that extends through the layer structure material down to the lower conductive wiring structure. In another embodiment, the vertical wiring connection is realized by a vertical connection (via, pillar, etc.) that extends (through layer structure material) between the two conductive wiring structures. In an embodiment, the vertical wiring connections may have the same width as the conductive wiring structures or may be larger.

In an embodiment, at least one layer structure (of the bridge element) is flipped with respect to the adjacent layer structure (compare Figure 6E). In an embodiment, the at least one conductive wiring structure of said layer structure is flipped (with respect to at least one further layer structure, in particular a further conductive wiring structure in said further layer structure, of the bridge element). In other words, the location of the conductive wiring structure (e.g. a copper trace) changes the position and/or orientation in regard to thickness direction. In an embodiment, two conductive wiring structures are exposed at the respective one of the two opposed main surfaces of the bridge element. This may provide the advantage that conductive wiring structures are exposed at both opposed main surfaces of the bridge element, thereby increasing versatility and applications. In an embodiment, the two lateral walls of the at least one conductive wiring structure of the flipped (external) layer structure are both inclined in an opposed slanted shape with respect to the slanted shape of the lateral walls of the at least one conductive wiring structure of the other layer structure(s) composing the bridge element and/or the slanted shape of the vias provided at the same electrically insulating layer structure(s).

In an embodiment, at least one of the plurality of layer structures has a vertical (additionally or alternatively horizontal) extension different to the other layer structures. Depending on the desired application, such a design may provide specific advantages, e.g. providing more/larger electric connections in a layer structure with larger dimensions. Additionally or alternatively, one of the layer structures composing the bridge element may be planarized on one of the main surface by the partial removal of the material on one main surface, preferably that defining one main surface of the bridge element.

In an embodiment, the conductive wiring structure has a different vertical extension compared to a further conductive wiring structure. This may provide the advantage that the conductive wiring structures may be adapted to their intended use. For example, smaller (fine line) structures may be used for signal transmission, while larger (thicker) structures may be used for power (high current) transmission.

In an embodiment, at least one further vertical connection connects the two opposed main surfaces of the at least one layer structure and/or the two opposed main surfaces of the bridge element. Said further vertical connection may extend through two or more layer structures of the bridge element, in particular through all layer structures. Thereby, a highly efficient interconnection for a large variety of applications may be provided. In an embodiment, the further vertical connection is formed by a single structure (via/pillar), even though it may extend through two or more layer structures. In an embodiment, the further vertical connection comprises two or more (stacked) structures (vias/pillars), for example one vertical connection structure per layer structure. In an embodiment, the further vertical connection may be independent/separated from the conductive wiring structure. In another embodiment, the further vertical connection may be connected to and/or extend through the conductive wiring structure.

In an embodiment, the at least one further vertical connection vertically extends through the whole bridge element. Thereby, the upper and lower (exposed) main surfaces may be interconnected, enabling an efficient and robust electric connection. For example, the component may be connected to an electrically conductive layer structure of the stack through the (further vertical connection of the) bridge element (compare Figure 5). Said connection may allow to route e.g. power supply from the stack through the bridge element to the high density area of the surface mounted component.

In an embodiment, the vertical extension of the at least one further vertical connection (vertically extending through the whole bridge element) has a planar extension greater than the planar extension of the at least one vertical connection. Thereby, a robust and reliable interconnection, in particular for higher current passage, may be enabled. Especially when the further vertical connection extends through a plurality of layer structures, a massive structure (with larger dimensions) may be advantageous.

In an embodiment, the at least one further vertical connection comprises: stacked vias/pillars in between two opposed main surfaces of stacked layers. Thereby, the interconnection within the bridge element may be provided in an efficient and design-flexible manner during the layer build-up of the bridge element, in particular without the need to drill through the (whole) bridge element.

In an embodiment, the stacked vias/pillars are decentered to each other, in particular being a footprint of two separate via/pillar manufacture processes. In an embodiment, the vias/pillars are stacked along the planar view of the stack. In an embodiment, the axes of the respective stacked vias/pillars do not overlap one to each other. In the present context, the term "decentered" may refer to a misalignment, where the center of one via does not perfectly align with the center of the other via in the stack. This structural feature may be a footprint of separate manufacture processes, e.g. layer structure by layer structure. Thereby, an efficient build-up may be enabled that build the electric (through) connections during the build-up process.

In an embodiment, at least one electrically conductive layer structure of the stack is connected to the at least one vertical connection of the bridge element. In an embodiment, at least one, in particular a plurality, of wiring structures are located in an opening within the at least electrically conductive layer structure in regard to the planar direction. Thus, the bridge element may be arranged in a design-flexible manner between electrically conductive structures of the stack and connected to these structures, enabling a large variety of functions. Specifically, the bridge element may enable the connection of the component(s) to electrically conductive layer structure of the stack.

In an embodiment, both surfaces, in particular main surfaces, of the bridge element are each connected with one of the at least one electrically conductive layer structure of the stack. For example, one main surface may be electrically connected through a redistribution structure of the stack to the components. In a further example, also the opposed main surface may be connected (e.g. through a connection structure) to further electrically conductive layer structures of the stack layer build-up.

In an embodiment, the at least one conductive wiring structure comprises a surface on/flushing with one main surface of the at least one layer structure. In an embodiment, this may be a footprint of a nano imprint lithography (NIL) manufacture process and/or of planarization made at one main surface of the layer structure composing the bridge element. In this manner, the conductive wiring structure may be manufactured in an efficient and straightforward manner, while an easy electric connection (exposed at the main surface of the layer structure) is enabled.

In an embodiment, the bridge element is assembled (at least partially embedded or surface mounted (e.g. in a cavity)) to one main surface of the stack. The bridge element may be at least partially embedded in the main surface of the stack, for example the upper main surface of the bridge element may be flush with the upper main surface of the stack (in particular except the outermost layer of the stack, which may be a solder resist layer). Preferably, the layer structure of the bridge element and the at least one conductive wiring structure of the bridge element may be flush with the upper main surface of the stack. This may provide the advantage of an easy electric connection to the (surface-mounted) components on top of the (upper main surface of) the stack. Alternatively, the upper main surface of the bridge element maybe embedded in the stack and electrically connected to the main surface of the stack.

In an embodiment, the bridge element is (at least partially) embedded in the stack, in particular in a cavity. This may provide the advantage that the bridge element may be assembled to the stack in an efficient manner using established techniques. When embedding the bridge element in the stack, space can be saved and the bridge element may be well protected by stack material, for example encapsulated in electrically insulating stack material. Preferably, one main surface and two sidewalls of the bridge element may be embedded in the stack. In an embodiment, one or more layers of the stack are covering the bridge element and may provide a direct connection to the surface mounted components or may provide an indirect connection by using the layers for further redistributing the signals.

In an embodiment, the bottom of the cavity is delimited by a base layer structure. In an embodiment, the base layer structure comprises an (electrically/thermally) conductive layer structure or an (electrically/thermally) insulating layer structure (of the stack). This may provide the advantage that the structure, defining the bottom of the cavity, can provide thermally/electrically conductive and/or insulating properties. Depending on the desired application, the bottom of the bridge element may be insulated, thermally conductive (e.g. to dissipate heat from the bridge element), and/or electrically conductive (e.g. electrically connecting (at part of the) bridge element). Additionally or alternatively, the base layer may help to align the bridge element in the cavity.

In an embodiment, the base layer structure has a thickness smaller (or larger) than the thickness of the at least one electrically insulating layer structure(s) of the stack defining the cavity. The base layer structure may hence be implemented as a thin support structure, thereby requiring less space while providing a robust mounting/connection of the bridge element. Additionally or alternatively, the smaller (or larger) thickness of the base layer can be the footprint of the different process (step) used to form the base layer and/or the additional step (subtractive-planarizing) on the surface of said base layer.

In an embodiment, the cavity has a planar extension (x, y) different to the planar extension of the bridge element. In an embodiment, the component carrier further comprises a dielectric encapsulation material (resin) flowed inside the cavity (and encapsulating at least partially the bridge element). In an embodiment, the planar extension of the cavity is similar to the planar extension of the bridge element. In other words, the planar extension of the cavity may be slightly different (greater) from the planar extension of the bridge element, for example in the range between 1% to 20% of the planar linear width of one of the cavity planar extensions and/or of the area of the cavity planar extension. In an embodiment, the planar extension of the cavity may be larger (e.g. more than 20%) than the planar extension of the bridge element in order to enable the flow of (more) encapsulation material into the cavity and efficiently encapsulation of the bridge element.

In an embodiment, the at least one electrically conductive layer structure of the stack is connected to the at least one (further) vertical connection of the bridge element by a connection structure. In an embodiment, the connection structure comprises or consists of an intermediate material/structure. In an embodiment, the connection structure is at least part of the base layer structure. In an embodiment, the connection structure comprises at least one of the following: a nanostructure, a microstructure, nanowires, micro-vias, solder material, Z-interconnection paste, a sintered material, an adhesive material. This may provide the advantage that the bridge element may be efficiently mechanically and/or electrically connected in the stack, depending on the desired application, eventually independently of coarse dimensional tolerances between the bridge element and the stack and/or the CTE mismatching between said bridge element and stack.

In the context of the present document, the term "nanostructures- and/or microstructures" may particularly denote physical structures with dimensions in the range of nanometers to micrometers, in particular having dimensions in a range between 0.1 nm and 10 micrometers, more particularly in a range between 1 nm and 500 nm. Preferably, the extension/dimension of the nanostructures and/or microstructures may be related to at least one, preferably two, directions perpendicular to stacking direction. A sheet having a surface equipped with such nanostructures and/or microstructures, for instance in an ordered way (for example in rows and columns and/or defining a pattern) or in a random way, may provide specific properties in terms of adhesion with adjacent component carrier material. Depending on the material, shape, dimension, coating and arrangement of the nanostructures and/or microstructures on the sheet surface, the nanostructures and/or microstructures may have an adhesive effect (such as at a leg of a gecko) or a repellent effect (such as on a surface of a lotus flower). A sheet may have at least 100, in particular at least 1000, nanostructures and/or microstructures. For instance, a sheet with nanostructures providing an adhesive property may be converted into a sheet with nanostructures providing a non-adhesive or even repellent property by a corresponding surface coating of the nanostructures and/or microstructures (for instance with a waxy material). For instance, the nanostructures and/or microstructures may be nano- and/or microprotrusions and/or nano- and/or microindentations. Preferably, the nanostructure and/or microstructures may be nanowires, in particular copper nanowires. In an example, the nanowires may have a cylindrical shape. In another example, the nanowires may have an aspect ratio of greater then 2, in particular greater than 5, more in particular greater than 10. This means that the radial extension of the nanowires is shorter by a factor of 2, in particular 5, more in particular 10, than the axial extension of the cylindrical shaped nanowire(s). Additionally or alternatively, the nanostructures and/or microstructures may comprise metallic particles. Preferably, the metallic particles may comprise an extension between 0.1 nm and 10 micrometers in one, preferably in all, spatial directions. In an example, the nanostructures and/or microstructures may comprise a paste comprising the metallic particles, for example a sinter paste and/or solder paste.

In an embodiment, the connection structure, in particular the intermediate material/structure (e.g. at least partially configured as the base layer structure), is arranged at the bottom of the cavity to fix the bridge element to the stack. This may enable a robust placement of the bridge element in the stack. In an embodiment, the connection structure is an intermediate structure (e.g. solder material) between an electric contact of the bridge element and an electrically conductive layer structure of the stack. This application may enable efficient wiring in the stack.

In an embodiment, the component carrier comprises a redistribution structure provided above the at least one electrically insulating layer structure. The redistribution structure may be provided on/at the bridge element and the exposed layer structure of the stack in regard to thickness direcetion. In an embodiment, said redistribution structure is configured to redistribute the connection to the two or more components. The redistribution structure may comprise electrically conductive layer structures (e.g. configured as pads/traces and/or vias) of the stack, in particular embedded in electrically insulating material of the stack. The redistribution structure may be configured to translate between different sizes/dimensions of electric contacts. For example, the bridge element may comprise small electric contacts at the upper main surface, while the stack may comprise large electric contacts (e.g. solder balls) at the upper main surface. The components may be placed onto said large electric contacts for connection (compare Figure 5). The redistribution structure may enable an efficient and reliable connection by forming an interface between the small electric contacts and the large electric contacts and/or to move the electric contacts in dislocated area(s) at the opposed side of the redistribution structure.

In an embodiment, the dimension of said redistribution structure is different, in particular larger, than the dimension of the conductive wiring structure of the bridge element. In an embodiment, the bridge element comprises a higher density (regarding electrically conductive structures) compared to the stack, in particular the outermost layer of the stack. Using established techniques (e.g. via and pad), a translation between these dimensions/densities may be enabled.

In an embodiment, at least one electrically insulating layer structure is provided on the main surface of the at least one layer structure of the bridge element. In an embodiment, the at least one electrically insulating layer structure comprises at least one opening that at least partially exposes the at least one conductive wiring structure and/or at least one via connection of the bridge element. In an embodiment, the at least one opening is filled with conductive material,
in particular at least one of a via, a pillar, a solder material. Thereby, the embedded bridge element may be electrically connected (e.g. to the surface-mounted components) in an efficient highly accurate manner.

In an embodiment, the at least one electrically insulating layer structure is the outermost layer of the stack. In an embodiment, the at least one electrically insulating layer structure comprises a solder resist. Additionally or alternatively, the at least one electrically insulating layer structure may be an element of the redistribution structure. Thereby, an efficient protection of stack surface and also of the embedded bridge element may be provided.

In an embodiment, the outermost layer structure of the plurality of layer structures (of the stack) comprises a different thickness, in particular is thinner, than one of the other layer structures (of the stack). In particular, in case of a solder resist layer, a smaller thickness may save space and material.

In an embodiment, one of the respective conductive wiring structures of the at least two of the plurality of layer structures comprises a different thickness than the other conductive wiring structures, in particular is thinner. Preferably, the thinner conductive wiring structure may be provided on the outermost layer of the bridge element. Alternatively or additionally, the thinner conductive wiring structure may be provided at the exposed surface of the bridge element. This feature may be a footprint of a material-removal process during the manufacture. For example, the surface of the bridge element and/or layer structure (with the embedded conductive wiring structure) may by processed, e.g. by grinding/routing, thereby removing material. Such a processed surface may be free of residues and/or smooth, thereby providing advantageous applications.

In an embodiment, the outermost layer structure of the bridge element and one (electrically insulating) layer (in particular defining the cavity) of the stack (and in particular a dielectric encapsulation material) are flush one to each other. This may provide the advantage that an efficient layer build-up may be realized, e.g. directly on the flush surface. Further, this feature may be the footprint of a material removal process, e.g. to generate an even surface without residues. Additionally or alternatively, the at least one wiring structure and the at least one electrically conductive layer structure may be provided on the same vertical level in regard to thickness direction and thus may be (vertically) connected to another electrically conductive layer structure in a fast and easy manner due to the location in the same vertical level.

In an embodiment, the component carrier further comprises a constant scratching distribution on the outermost layer structure of the bridge element and/or the stack (and in particular the dielectric encapsulation material). This structural feature may be a footprint of a material removal (e.g. grinding/routing) manufacture process, eventually provided in one step on the whole main surface of the stack at the level the bridge element is exposed. Thereby, an even/smooth surface without residues may be provided; thereby improving the performance of the component carrier.

In an embodiment, the external layer structure of the bridge element is flipped, wherein no conductive wiring structure is exposed at the external layer of the bridge element and the stack (and in particular also the dielectric encapsulation material). In an embodiment, the component carrier further comprises one or more protrusions, in particular vias/pillars, above the exposed via connections of the bridge element. In an embodiment, said protrusions (e.g. portions of a surface conductive wiring structure) may be larger than the portions/traces of the conductive wiring structure. This may bring the advantage of mechanically protecting the wiring structure associated to the external layer structure of the bridge element, while assuring the external connection of said wiring structure.

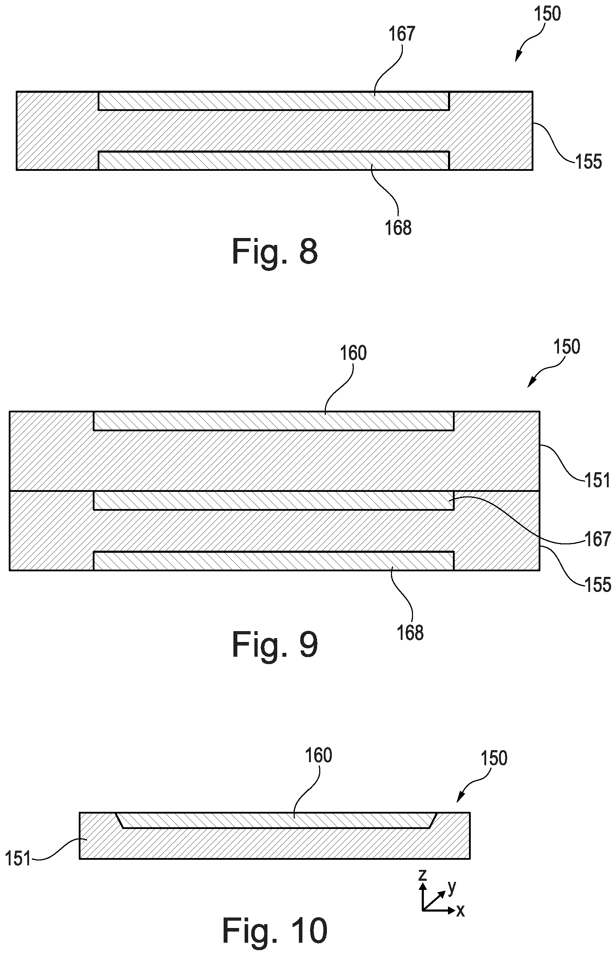

In an exemplary embodiment, the at least one layer structure comprises two (or more) conductive wiring structures, in particular wherein an upper conductive wiring structure is embedded at the upper main surface of the layer structure and/or wherein a lower conductive wiring structure is embedded at the lower main surface of the layer structure (compare Figures 8 and 9). This may provide the advantage that the layer structure comprises an exposed conductive wiring structure at each main surface. Further, an efficient manufacturing process may be provided: material removal (e.g. laser trenching) and material filling (e.g. copper filling) can be done from one side of the layer structure. Then, the layer structure is flipped, and the same process may be done from the other side. Alternatively, the material removal of the at least one layer structure may be executed on both opposed main surfaces and two conductive wiring structures may be provided on both opposed main surface simultaneously.

In an embodiment, the at least one conductive wiring structure has a different function than the at least one further vertical connection between the two opposed bridge element main surfaces. In an embodiment, the at least one conductive wiring structure is configured for signal transmission. In an embodiment, the at least one further vertical connection is configured for power/ground transmission. In an embodiment, the vias of the component carrier (besides the bridge element) are configured for power/ground transmission, while the bridge element is mainly configured for signal transport. In an embodiment, the bridge element comprises (metal filled) through holes for power/ground transmission and other (smaller) traces (conductive wiring structure) for signal transport. In this manner, the desired functionalities may be optimized.

In an embodiment, the at least one conductive wiring structure has a smaller surface extension along the cross-section perpendicular to the bridging direction than the surface extension of the at least one vertical connection and/or of the at least one further vertical connection (in particular along the vertical extension of the (further) vertical connection). In an example, the at least one conductive wiring structure may have a smaller surface extension along the cross-section perpendicular to the bridging direction being at least 10% smaller than the surface extension of the at least one vertical connection and/or of the at least one further vertical connection (in particular along the vertical extension of the (further) vertical connection). Thus, the (further) vertical connection may comprise a larger dimension being more suitable for power/ground transmission, while the conductive wiring structure may comprise a smaller dimension being more suitable for signal transport.

In an embodiment, the at least one conductive wiring structure is a stamped profile, in particular being a footprint of a nano imprint lithography manufacture process. A "stamped profile" may refer to the shape or contour of a conductive structure that is formed by pressing a patterned mold into a resist layer. This imprinted pattern may later be used for metal deposition, creating the final conductive wiring structure. The stamped profile may hence define the cross-sectional geometry of the structure.

In an embodiment, the at least one conductive wiring structure is encapsulated by a dielectric encapsulation material, in particular a dielectric material composing the bridge element, and/or a dielectric material composing the stack (in particular composing the outermost layer structure, more in particular the solder resist). When the bridge element is embedded at the upper main surface of the stack and the outermost layer is a solder resist layer, the bridge element may be arranged directly below the solder resist layer. Thereby, the solder resist layer may efficiently protect the bridge element, and the bridge element may have very short distances for providing the electric interconnection of the components.

In an embodiment, the at least one conductive wiring structure has a different cross-section and/or a different line/space (L/S) than the electrically conductive layer structure of the stack (in particular is smaller). In an embodiment, the conductive wiring structure comprises a different thickness and/or different width and/or different density compared to the electrically conductive layer structure of the stack. Preferably, the bridge element (which comprises a plurality of interconnections) may be designed with a higher electric connection density than the stack. Such a higher electronic connection density may ensure a reliable, compact and fast transmission of signals between the at least two components being connected by the bridge element. Such smaller connections, in particular with smaller line spacing, may be realized by specific processes such as NIL or by using a laser (trench) process.

In an embodiment, the bridge element provides 10 or more, in particular 100 or more, more in particular 1000 or more, electric connections for the two or more components. This may provide the advantage that the bridge element can be directly applied for common semiconductor element components such as an integrated circuit or high bandwidth memory, which generally comprises a high number of electric contacts and/or a higher density of electrically conductive layer structures with respect to the density of the electrically conductive layer structures in the stack, in particular those adjacent to the bridge element.

In an embodiment, the bridge element is (essentially) free of silicon material. In comparison to conventional bridges, the described bridge element comprises an organic material. Accordingly, established component carrier manufacture techniques and materials may be directly applied. Using a comparable material for the bridge element as for the stack may increase the integrity (e.g. regarding thermal expansion).

In the context of the present document, the term "silicon" may in particular refer to elementary silicon and/or metallic silicon. Even though glass can comprise silicon dioxide (SiO₂), this may not be considered as silicon in the present context. For example, a layer structure may be reinforced by glass spheres/fibers. Nevertheless, the bridging element may still be considered as silicon-free as the glass may not contain elementary/metallic silicon.

In an embodiment, the bridge element is free of an isolated exposed pad. While conventional bridges use isolated exposed pads for electric connection, the described bridge element may comprise (exclusively) the exposed at least one conductive wiring structure (e.g. as a plurality of traces).

In an embodiment, the at least one wiring structure, in particular the outermost one(s) with respect to the bridge element and/or the stack, comprises a surface finish. For example, the surface finish comprises silver, nickel and/or gold. This may protect the wiring structure from environmental impact, for example oxidation.

In an embodiment, providing/forming the bridge element, in particular the conductive wiring structure, further comprises at least one of a nano imprint lithography (NIL) process, a reactive ion etching (RIE) process, a laser trench process or a (laser based) imaging process using photoimageable dielectric (PID) material. These specific manufacture methods may be especially suitable to generate, in a precise manner, a high density (fine line) conductive wiring structure. Each of these methods generates as a footprint inclined lateral walls, when seen in a direction perpendicular to the bridging direction.

In an embodiment, the method of forming the bridge element, in particular the conductive wiring structure, comprises structuring a PID material by using a laser direct imaging process. Alternatively, the conductive wiring structure may be formed by using a photo mask while exposing at least a portion of the layer structure of the bridge element with electromagnetic waves. The untreated areas/portions will be removed leading to the indentations which will become the conductive wiring structures finally after seed layer and (copper) plating. Between two layers of conductive wiring structures, a further cured insulating layer (e.g. PID) may be placed, as the UV light during exposure tends to fully remove uncured PID.

NIL may be a high-resolution, cost-effective nanofabrication technique used to create micro- and nanoscale patterns. The process steps may involve for example:
Resist coating: a liquid or thermoplastic resist layer is applied to the substrate. Mold imprinting: a patterned mold (template) is pressed into the resist under controlled pressure.
Resist solidification: the resist is hardened, e.g. using heat (thermal NIL) or UV light (UV-NIL).
Mold release: the mold is removed, leaving an inverse pattern (negative) in the resist.
Pattern transfer: the imprinted pattern is used for further processing, such as etching or metal deposition, to create functional structures.

In an embodiment, the resist of the NIL process provided may correspond to the at least one layer structure of the bridge element. The imprinted and hardened structures may then be filled with electrically conductive material to create the at least one conductive wiring structure.

In an exemplary example, NIL may enable high-resolution patterning with sub-10 nm features. In an exemplary embodiment, the inclined sidewalls may be created at least partially by removing the stamp.

RIE may be a dry etching technique used in microfabrication to precisely remove material (from a bridge element) using chemically reactive plasma. The process steps may involve:
Plasma generation: a low-pressure gas (e.g., SF₆, CF₄, O₂) is ionized, e.g. using an RF (radio frequency) electric field,
Chemical and physical etching: the generated reactive ions chemically react with the substrate while ion bombardment enhances directionality, enabling anisotropic etching.
RIE may achieve precise etching with minimal undercutting.
RIE may also be combined with NIL.

In an embodiment, RIE may produce inclined lateral walls according to at least one of the following: in an ideal anisotropic etch, ions strike the at least one perpendicularly. However, ion scattering and non-uniform acceleration can lead to angled etching, creating sloped sidewalls; if the etch mask degrades or is not perfectly vertical, it can cause lateral etching at the edges, resulting in tapered sidewalls; some etching gases (e.g., CF₄, SF₆) cause isotropic chemical reactions that slightly etch sideways, further inclining the walls; higher pressure, lower RF power, or gas composition changes can influence ion trajectory, leading to non-vertical profiles.

Laser trenching may be a material removal process that uses a focused laser beam to create precise trenches or grooves in a substrate. It may be inherent to laser-based material removal processes, that inclined sidewall are produced (compare common laser vias).

In an embodiment, the above described processes create the tapered shape cavity in the at least one layer structure of the organic dielectric material and afterwards, a metal deposition process is performed in order to provide the at least one conductive wiring structure.

In an embodiment, providing/assembling the bridge element further comprises: embedding the bridge element in the stack (for example in a preformed cavity in the stack). In an embodiment, embedding the bridge element in the stack further comprises placing the bridge element in a cavity of the stack. Thereby, established techniques can be directly applied. In the stack, the bridge element may be protected and save space.

In an embodiment, the method further comprises removing material from the external surface, so that the external bridge element layer structure comprises a different thickness than one or more other layer structures, in particular is thinner (e.g. by grinding/routing). In an embodiment, the method further comprises removing material from the external surface, so that the external bridge element conductive wiring structure comprises a different thickness than one or more other conductive wiring structures, in particular is thinner. In an embodiment, the method further comprises removing material from the external surface, so that the external layers of the bridge element and the respective layer of the stack, in particular also the dielectric encapsulation material, are flush.

In an embodiment, the removing of material comprises grinding/routing,
in particular so that a constant scratching distribution is provided on the external layers of the bridge element and the stack, in particular also the dielectric encapsulation material.

In an embodiment, the method further comprises forming at least one (further) via connection in the bridge element (in particular after or before assembling the bridge element to the stack). In an embodiment, the method further comprises forming the (further) vertical connection on the layer structure composing the bridge element to connect the (embedded) conductive wiring structure. In an embodiment, the method further comprises stacking at least two layer structures composing the bridge element and subsequently forming the (further) vertical connection exposing the (embedded) conductive wiring structure or to pass through the entire thickness of the at least two layer structures. Thus, electric connections may be formed in a design-flexible manner using established component carrier manufacture techniques.

In an embodiment, the bridge element may comprise at least one component. Preferably, the at least one component may be embedded in the bridge element, in particular in the at least one layer structure. The at least one component may be electrically connected by the at least one conductive wiring structure. This may bring the advantage of providing a functionality into the bridge element, for example by embedding an active component or passive component. In an example the component may comprise a capacitor and/or a resistor and/or a transistor. In case of embedding the at least one component in the bridge element, the signal integrity and/or power integrity may be enhanced.

In an exemplary embodiment, the method may comprise at least one of the following aspects:
i) the conductive wiring structures (traces) can be provided on an organic panel (i.e. through NIL, laser trenching process, etc.), and are then filled with conductive material. Such a panel can then be singularized, resulting in a plurality of layer structures. These can be used singularly or stacked with proper vertical connection, acting as the bridge element.
ii) the connection of the layer structures can be realized through not fully cured organic dielectric, subsequently cured, and/or glue structures, and/or sintering-connection between the through vias of the respective layer structures.
iii) the resulting bridge element can be attached on the component carrier and/or in the stack and/or through a connecting element.
iv) the vertical connection can be formed before or after the stacking of the layer structures forming the bridge element.

In an embodiment, at least some of the vertical connections can be formed on the bridge element once assembled in the component carrier; eventually associating the position of the vertical connection to alignment marks on the bridge element and/or on the component carrier. This may provide the advantage that the organic material forms both, the stack and the bridge element, leading to the possibility to use the same process (step) to form the vertical connections.

In an embodiment, these steps can be associated to an external planarization of the stack and the bridge element, once the bridge element is assembled (in particular embedded). This may be efficiently associated with a subsequent alignment and/or vertical connection formation process.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board.

A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene derivate (e.g. based on polyphenylenether, PPE), polyimide (PI), polyamide (PA), liquid crystal polymer (LCP), polytetrafluoroethylene (PTFE), Bisbenzocyclobutene (BCB) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, titanium and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component (in particular the embedded component), which may be surface mounted on and/or embedded in the component carrier, can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be surface mounted on the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.

### Brief Description of the Drawings

Figure 1A illustrates a cross-section of a component carrier with a bridge element, according to an exemplary embodiment of the invention.
Figure 1B illustrates a cross-section of the bridge element in the bridging direction, according to an exemplary embodiment of the invention.
Figure 1C illustrates a cross-section of the bridge element in a direction perpendicular to the bridging direction, according to an exemplary embodiment of the invention.
Figure 2A illustrates a cross-section of the component carrier with the bridge element, according to a further exemplary embodiment of the invention.
Figure 2B illustrates a cross-section of the bridge element in the bridging direction, according to a further exemplary embodiment of the invention.
Figure 3 illustrates a cross-section of the component carrier with the bridge element having two layer structures, according to an exemplary embodiment of the invention.
Figure 4 illustrates a cross-section of a component carrier with a bridge element and a connection structure, according to an exemplary embodiment of the invention.
Figure 5 illustrates a cross-section of the component carrier with surface-mounted components, according to an exemplary embodiment of the invention.
Figure 6A, Figure 6B, Figure 6C, Figure 6D, and Figure 6E respectively illustrates a cross-section of the bridge element with two or more layer structures, according to exemplary embodiments of the invention.
Figure 7 illustrates a conventional circuit board with a bridge.
Figure 8 illustrates a layer structure of the bridge element with an embedded conductive wiring structure exposed at each main surface, according to an exemplary embodiment of the invention.
Figure 9 illustrates the layer structure of Figure 8 arranged in a stack of the bridge element, according to an exemplary embodiment of the invention.
Figure 10 illustrates the two lateral walls, both inclined with respect to the stack thickness direction along a cross-section parallel to the bridging direction, according to an exemplary embodiment of the invention.

### Detailed Description of the Drawings

**Figure 1A** illustrates a cross-section of a component carrier 100 with a bridge element 150, according to an exemplary embodiment of the invention. The component carrier 100 comprises a stack 101 preferably with a core layer 103 and a build-up structure 106 (for example a plurality of alternating electrically insulating layer structures 102 and electrically conductive layer structures 104) on top of the core layer 103, and at least one electrically insulating layer structure 102 on top of the build-up structure 106. The stack 101 further comprises a plurality of electrically conductive layer structures 104. Exposed electrically conductive layer structures 104 at the main surface of the stack 101 are covered/protected by a surface finish 108. Figure 1 is focused on the build-up structure on top of the core layer 103. Yet, a further build-up structure (not shown) can also be arranged below the core layer 103 (compare e.g. Figure 5).

A bridge element 150 is preferably embedded in the electrically insulating layer structure 102 (on top of the build-up structure 106 in the shown embodiment) and encapsulated by electrically insulating material. The encapsulation material encapsulating the bridge element 150 may be at least partially provided by the electrically insulating layer structure 102. The bridge element 150 is configured for connecting at least two components (not shown, compare Figure 5) one to each other. The bridge element 150 comprises at least one layer structure 151 (in the example of Figure 1 exactly one layer structure 151) made of organic dielectric material (e.g. ABF) and at least one conductive wiring structure 160 (in Figure 1 one conductive wiring structure 160 in form of a copper trace is shown). The conductive wiring structure 160 extends along a bridging direction, being a (virtual) straight direction to connect the two portions (pads) of the two respective components that are connected one to each other by the conductive wiring structure 160 of the bridge element 150. In the example of Figure 1, the conductive wiring structure 160 is configured as an electrically conductive trace, and the bridging direction may be oriented along the x-axis.

The bridge element 150 is preferably embedded in a cavity (not explicitly shown) in the stack 101, wherein the bottom of the cavity is preferably delimited by a base layer structure 120, here an electrically conductive layer structure 104. Said base layer structure 120 preferably has a thickness smaller than the thickness of the at least one electrically insulating layer structure 102 of the stack 101 defining the cavity. Furthermore, the base layer structure 120 preferably has a size larger than the bridge element 150. The outermost layer structure of the bridge element 150 and one layer of the stack 101 (here the electrically insulating layer structure 102) are preferably flush one to each other.

A further electrically insulating layer structure 105 (on top of the electrically insulating layer structure 102) can be the outermost layer of the stack 101 and optionally may fill a gap between the bridge element 150 and the electrically insulating layer 102 within the cavity (not shown), preferably said further electrically insulating layer structure 105 comprises a solder resist material. Via connections 107 (here laser vias) may be connected to the conductive wiring structure 160 and extend through the solder resist layer 105, thereby enabling a connection to the embedded bridge element 150. Preferably, the via connection 107 comprises electrically conductive material, for example the via connection 107 may be composed as a metal filled connection. On top of the via connections 107, respective solder balls/bumps 112 may be formed. These can be further connected to respective components (not shown, see Figure 5) that can be interconnected through the bridge element 150, in particular using the conductive wiring structure 160 along the bridging direction. The Figure also shows a metal filled vertical connection connecting the two surfaces of the electrically insulating layer structure 102. The vertical connection has the same thickness as the thickness of the bridge element 150.

**Figure 1B** illustrates a cross-section of the bridge element 150 in the bridging direction, according to an exemplary embodiment of the invention. As described above, the conductive wiring structure 160 may be configured as a trace, preferably embedded in the upper main surface of the layer structure 151 of the bridge element 150, wherein the upper main surface of the conductive wiring structure 160 and the upper main surface of the layer structure 151 are flush. In this example, the two components will be connected along the length direction of the conductive wiring structure 160. Therefore, in this example, the bridging direction may extend parallel to the x-axis (direction of main extension of the conductive wiring structure 160). The width of the conductive wiring structure 160 can be smaller than the width of the layer structure 151. The side walls of the conductive wiring structure 160 can be exclusively in contact with the layer structure 151. The conductive wiring structure 160 may be partially embedded in the layer structure 151. In an embodiment, the bridge element 150 has a base layer (not shown) in order to mechanically stabilize (stiffen) the bridge structure. Preferably, it is made of copper, glass or a reinforced organic material.

**Figure 1C** illustrates a cross-section of a portion of the bridge element 150 in a plane perpendicular to the bridging direction, according to an exemplary embodiment of the invention. The cross-section of Figure 1C is perpendicular to the cross-section of Figure 1B, thus showing a cut along the y-axis. In this particular example, a direction parallel to the y-axis may be seen as perpendicular to the bridging direction.

The at least one conductive wiring structure 160 may comprise a bottom portion and an upper portion connected by two lateral walls 165, 166. It can be seen that the two lateral walls 165, 166 define a slanted shape preferably toward to the (interior of the) at least one layer structure 151 (in other words: tapering from top to bottom, tapering towards the interior of the layer structure 151). Thus, along a cross-section perpendicular to the bridging direction, the at least one conductive wiring structure 160 comprises at least two lateral walls 165, 166, preferably both inclined with respect to the stack thickness direction z (stacking direction). Such a structure can be the footprint of a specific manufacture process (in particular providing precisely a fine line structure), e.g. a nano imprint lithography process, a reactive ion etching process, a laser trench process or a process using photoimageable dielectric material.

**Figure 2A** illustrates a cross-section of the component carrier 100 with the bridge element 150, according to a further exemplary embodiment of the invention. In comparison to Figure 1A, the conductive wiring structure 160 is not embedded in the upper main surface of the layer structure 151, but instead in the lower main surface of said layer structure 151. Hence, the lower main surface of the conductive wiring structure 160 and the lower main surface of the layer structure 151 are flush. In this example, the base layer structure 120 is an electrically insulating layer structure (e.g. an adhesive such as a glue).

The shown bridge element 150 comprises two vertical connections 170 (here implemented as metal filled vias), extending from the upper main surface of the layer structure 151 through the layer structure 151 down to the conductive wiring structure 160 at the bottom of the layer structure 151. The vertical connections 170 may be respectively connected to the via connections 107 described for Figure 1A above. In this manner, components (not shown, see Figure 5) can be interconnected by the at least one conductive wiring structure 160 through the vertical connections 170 (the vertical connections 170 and the conductive wiring structure 160 form together a U-like shape). In an embodiment, the vertical connection 170 is manufactured by a separate process step compared to via connection 107 and therefor can be distinguished from the via connection 107. Alternatively, the bridge element 150 may be embedded first and then, the connection to the conductive wiring structure 160 is formed after embedding. In this case, the vertical connection 170 and the via connection 107 can be formed in the same process.

**Figure 2B** illustrates a cross-section of the bridge element 150 in the bridging direction, according to a further exemplary embodiment of the invention. As described above, in comparison to Figure 1B, the conductive wiring structure 160 is not embedded in the upper main surface of the layer structure 151, but in the lower main surface of the layer structure 151.

**Figure 3** illustrates a cross-section of the component carrier 100 with the bridge element 150 having two layer structures 151, 152 according to an exemplary embodiment of the invention. The component carrier 100 is comparable to the one described for Figure 1A, yet comprises two electrically insulating layer structures 102 stacked on top of each other, wherein the bridge element 150 is embedded into both of said two electrically insulating layer structures 102. Alternatively, a bridge element having a plurality of layer structures may be embedded in one electrically insulating layer (not shown). The interface between the layer structures 151 and 152 is on the same vertical position as the interface between the electrically insulating layer structures 102, where the bridge element 150 is embedded in.

The two stacked layer structures 151, 152 of this bridge element 150 are each preferably made of organic dielectric material and each preferably comprises a respective conductive wiring structure 160, 161 extending along the bridging direction. In the cross-section perpendicular to the bridging direction, the at least one respective conductive wiring structure 160, 161 comprises at least two lateral walls 165, 166, both inclined with respect to the stack thickness direction (not shown in this Figure). The conductive wiring structure 161 of the lower layer structure 152 is connected to respective via connections 107 by vertical connections 170 that extend in the vertical direction through the upper layer structure 151. The vertical connections 170 have the same thickness as the upper layer structure 151 and/or the vertical connections 170 are free from direct contact with the upper wiring structure 160. This is possible because the extension (length) of the upper conductive wiring structure 160 is smaller than the extension of the lower conductive wiring structure 161. The lower conductive wiring structure 161 is free from direct contact with the upper conductive wiring structure 160.

**Figure 4** illustrates a cross-section of a component carrier 100 with a bridge element 150 and a connection structure, according to an exemplary embodiment of the invention. Figure 4 is comparable to Figure 3, yet comprises an additional connection structure instead of the base layer structure 120. Using said connection structure, the bridge element 150 can be electrically connected to the stack 101, in particular to an electrically conductive layer structure 104 of the stack 101. In this embodiment, the connection structure is configured as an intermediate material 122, here a solder or sinter material, arranged between an electric contact 121 at the bottom of the bridge element 150 and the electrically conductive layer structure 104 of the stack 101. Said electric contact 121 (e.g. a pad) is connected to a respective via connection 107 (on top of the bridge element 150) by vertical connections 170 that extend vertically through the lower layer structure 152 and the upper layer structure 151 of the bridge element 150. The intermediate material/structure 122 is arranged in this embodiment at the bottom of the cavity (and embedded in the electrically insulating material) to fix the bridge element 150 to the stack 101.

The interface between the layer structures 151 and 152 is at a different vertical position as the interface between the electrically insulating layer structures 102, where the bridge element 150 is embedded in. Additionally, at least one conductive wiring structure may be connected to the electric contact 121 and/or intermediate material 122 (not shown).

The electric contact 121 and the intermediate material/structure 122 are also connected to the further vertical connection 171, connecting the electrically conductive layer structure 104 of the stack 101 and the electric contact 121 with an external bump-connection 112 for the respective component contact, in particular suitable for the power connection to the component. The further vertical connection 171 comprises, in this example, a larger planar extension than the vertical connection 170 and the conductive wiring structures (in cross-section).

**Figure 5** illustrates a cross-section of the component carrier 100 with surface-mounted components 110, 111, according to an exemplary embodiment of the invention. In this example, the component carrier 100 comprises a larger stack 101 than in the examples of Figures 1 to 4, wherein the core layer 103 is sandwiched between an upper layer build-up 106a and a lower layer build-up 106b. A plurality of upper electrically insulating layer structures 102a are stacked on the upper layer build-up 106a and a plurality of lower electrically insulating layer structures 102b are stacked on the lower layer build-up 106b. The outermost layer at the upper main surface and at the lower main surface of the stack 101 is a respective solder resist layer 105. An electrically conductive through connection 109 vertically extends through the whole stack 101 and electrically connects the upper main surface with the lower main surface of the stack 101. The electrically conductive through connection 109 may be a mechanically drilled through connection being fully filled with copper.

The bridge element 150 of Figure 5 is designed in a comparable manner as described for Figure 4. Yet, the intermediate structure 123 is different: instead of a solder material, nanostructures or microstructures are arranged between the electric contact 121 of the bridge element 150 and the electrically conductive layer structure 104 of the stack 101. The embedded bridge element 150 is electrically connected through via connection 107 to the exposed solder balls 112 at the upper main surface of the stack 101.

It is shown in Figure 5 that the component carrier 100 comprises two surface-mounted components 110, 111 (e.g. semiconductor elements such as ICs) (a component carrier arrangement). Said components 110, 111 are placed onto the solder balls 112 and electrically connected, via the solder balls 112 and the via connections 107, to the embedded bridge element 150. In the embodiment of Figure 5, the right-side electric contact of the first component 110 and the left-side electric contact of the second component 111 are electrically interconnected through the upper conductive wiring structure 160 in the upper layer structure 151 of the bridge element 150 (connected in bridging direction). The second electric contact from the right side of the first component 110 and the second electric contact from the left side of the second component 111 are electrically interconnected through the lower conductive wiring structure 161 in the lower layer structure 152 of the bridge element 150 (also connected in bridging direction). In this cross-section, each interconnection (of vias and respective conductive wiring structure) has a U-like shape.

Further electric contacts of the components 110, 111 are electrically connected to respective electrically conductive layer structures 104 of the stack 101. Vertical connections that extend through the bridge element 150 are also applied for interconnecting electric contacts of the components 110, 111 to electrically conductive layer structures 104 of the stack 101 (in particular through the intermediate material 123).

Further, a redistribution structure 180 is provided above the electrically insulating layer structure 102 in which the bridge element 150 is embedded. Said redistribution structure 180 is configured to redistribute the bridge element 150 connections to the two components 110, 111. The dimension of said redistribution structure 180 is larger, in this example, than the dimension of the conductive wiring structure 160 of the bridge element 150. In particular, the bridge element 150 comprises a higher density of electric connections than the stack 101 and the components 110, 111.

In this embodiment, the part below the core layer 103 has lower metal (e.g. copper) density and said part below the core layer 103 has no bridge element 103 embedded. The vertical connection between the bridge element 150 and the left component 110 has tapered shape (e.g. laser via). Further, the vertical connection between the bridge element 150 and the right component 111 has a non-tapered shape (e.g. copper pillar, or opening in a PID).

The upper electrically insulating layer structure 102 is thinner than the other electrically insulating layer structures 102 due to a possible grinding process to flatten the surface after embedding of the bridge element 150. Preferably, a bridge with copper pillars (like in Fig. 6C) is embedded, so that, after grinding, the copper pillars are exposed and may be connected in a padless manner.

The electric contact 121 and the intermediate material/structure 123 are also connected to the further vertical connection 171, connecting the electrically conductive layer structure 104 of the stack 101 and the electric contact 121 with an external bump-connection 112 for the respective component 110 contact, in particular suitable for the power connection to the component 110. The further vertical connection 171 comprises, in this example, a larger planar extension than the vertical connection 170 and the conductive wiring structures (in cross-section).

**Figure 6A, Figure 6B****,** **Figure 6C, Figure 6D, and Figure 6E** respectively illustrates a cross-section of the bridge element 150 with two or more layer structures 151, 152, 153, according to exemplary embodiments of the invention.

**Figure 6A****:** in this embodiment (compare Figure 4), the bridge element 150 comprises two stacked layer structures 151, 152, each comprising a respective conductive wiring structure 160, 161 embedded in the layer structure upper main surface. A vertical connection 170 (e.g. a via or pillar) extends through the upper layer structure 151 and thereby connects the embedded lower conductive wiring structure 161 of the lower layer structure 152 to the exposed upper main surface of the bridge element 150. A further vertical connection 171 (see description above) extends through both layer structures 151, 152 and connects the upper main surface with the lower main surface of the bridge element 150. Said further vertical connection 171 is not connected to the embedded conductive wiring structures 160, 161. At the left side, the further vertical connection 171 is realized by a single via, while at the right side, the further vertical connection 171 is realized by two stacked vias. The via connection 170 in the upper conductive wiring structure 151 and the via connection in the lower conductive wiring structure 152 are connected, thereby forming together a stacked vertical connection 174.

**Figure 6B****:** shows a cross-section of the bridge element 150 of Figure 6A, yet the viewing direction is perpendicular to the viewing direction of Figure 6A (perpendicular to the bridging direction). It can be seen that the upper conductive wiring structure 160 and the lower conductive wiring structure 161 respectively comprises a plurality of portions/traces. Each of said portions has inclined/slanted lateral walls, thereby reflecting a specific manufacture process underlining the design flexibility of these processes. It can be further seen that different portions can have different (extension) depths into the bridge element 150.

The vertical connection 170 (e.g. a via or pillar) extends through the upper layer structure 151 and thereby connects a portion of the embedded lower conductive wiring structure 161 of the lower layer structure 152 to the exposed upper main surface of the bridge element 150. Hereby, the via connection 170 and the respective portion of the lower conductive wiring structure 161 are connected.. Said the respective portion of the lower conductive wiring structure 161 (lower trace) is thicker (e.g. for the transport of current) and may be connected to the surface by a via (e.g. said via connection 170). The further vertical connection 171 extends through both layer structures 151, 152 and connects the upper main surface with the lower main surface of the bridge element 150.

Additionally, there is one portion of the upper conductive wiring structure 160 that extends vertically through the upper layer structure 151 and is electrically connected to one portion of the lower conductive wiring structure 161, thereby forming a vertical wiring connection 175 between conductive wiring structures 160, 161 in the bridge element 150. The vertical wiring connection 175 thus connects two conductive wiring structures 160, 161 of two adjacent and stacked layer structures 151, 152.

**Figure 6C****:** in this embodiment, a surface conductive wiring structure 163 is formed on top of the upper/exposed conductive wiring structure 160. This structure shows smaller conductive wiring structures (e.g. signal transport) and larger conductive wiring structures (current/ground transmission). Each exposed portion of the conductive wiring structure 160, each exposed part of the vertical connection 170, and each exposed part of the further vertical connection 171 is connected to a respective portion of the surface conductive wiring structure 163. Thereby, a flexible electric connection to the components 110, 111 can be enabled. It can be seen in this viewing direction (perpendicular to the bridging direction) that only the portions of the embedded conductive wiring structures 160, 161 comprises inclined lateral walls. The portions of the surface conductive wiring structure 163 instead are formed according to a different process (e.g. by an additive- or semi-additive process) and thus comprises straight lateral walls forming pillars. This structure is preferred if a grinding process is done after embedding, such that the pillars are exposed after grinding and thus allows both a direct contacting without creating pads or with pads.

Stacked vertical connections 174 are formed between a portion of the lower conductive wiring structure 161, a vertical connection 170 through the upper layer structure 160, and a portion (first pillar 172) of the surface conductive wiring structure 163. Further portions of the surface conductive wiring structure 163 (arranged only on respective portions of the upper conductive wiring structure 160) are termed second pillars 173 here. In this example, the pillars 172, 173 have a smaller width than the exposed conductive wiring structures 160 and the vertical connections 170, 171.

**Figure 6D****:** in this embodiment, the bridge element 150 comprises three stacked layer structures 151, 152, 153, each with a respective conductive wiring structure 160, 161, 162 embedded in the layer structure upper main surface. Vertical connections 170 (that extend through only one layer structure 151) connect the middle conductive wiring structure 161 to the upper main surface of the bridge element 150. Further vertical connections 171 (that extend respectively through two layer structures 151, 152) connect the lower conductive wiring structure 162 to the upper main surface of the bridge element 150.

In an embodiment, a component 164 is embedded in the bridge element 150. The component 164 is provided in the layer structure 152. Additionally the component 164 is electrically connected to the middle conductive wiring structure 161. The component 164 is electrically connected with the vertical connection 170.

**Figure 6E****:** in this embodiment, three layer structures 151, 152, 154 are stacked, like in Figure 6D. Yet, the lower layer structure 154 is flipped with respect to the adjacent (middle) layer structure 152. Thus, two conductive wiring structures 160, 161 are exposed at the respective one of the two opposed main surfaces of the bridge element 150.

**Figure 8** illustrates a layer structure 155 of the bridge element 150 with two embedded conductive wiring structures 167, 168, according to an exemplary embodiment of the invention. A first/upper conductive wiring structure 167 is embedded in the upper main surface of the layer structure 155 (the upper main surface of the embedded conductive wiring structure 167 and the upper main surface of the layer structure 155 being flush in this example) and is exposed at said upper main surface of the layer structure 155. A second/lower conductive wiring structure 168 is embedded in the lower/bottom main surface of the layer structure 155 (the lower main surface of the embedded conductive wiring structure 168 and the lower main surface of the layer structure 155 being flush in this example) and is exposed at said lower main surface of the layer structure 155. Thus, a respective embedded conductive wiring structure 167, 168 is exposed at each main surface of the layer structure 155.

In an exemplary embodiment, material removal (e.g. laser trenching) and material filling (e.g. copper filling) can be done from one side. Then, the layer structure is flipped, and the same process is done on the other side. When further stacking, only one further wiring structure can be included in the further layer structure, see Figure 9 below.

**Figure 9** illustrates a bridge element 150 with two stacked layer structures 151, 155, according to an exemplary embodiment of the invention. While the upper layer structure 151 is configured as described for Figure 1B, the lower layer structure 155 is configured as described for Figure 8. In this example, the bridge element 150 comprises a respective embedded conductive wiring structure 160, 168 exposed at each main surface. In an embodiment, the amount of layer structures 151, 155 may be different than the amount of conductive wiring structures 160, 167, 168. Alternatively, the amount of layer structures may be the same as the amount of wiring structures (see Figure 6E).

**Figure 10** illustrates an embodiment, wherein the at least one conductive wiring structure 160 comprises at least two lateral walls, both inclined with respect to the stack thickness direction, along a cross-section parallel to the bridging direction, according to an exemplary embodiment of the invention.

### Reference signs

- 100: Component carrier
- 101: Stack
- 102: Electrically insulating layer structure
- 103: Core layer structure
- 104: Electrically conductive layer structure
- 105: Surface layer structure, solder resist
- 106: Further layer build-up
- 107: Via connection
- 108: Surface finish
- 109: Electrically conductive through connection
- 110: First component
- 111: Second component
- 112: Electric connection, solder ball
- 120: Base layer structure
- 121: Electric contact
- 122: Intermediate material, solder
- 123: Further intermediate material, micro-vias
- 150: Bridge element
- 151: (First) layer structure
- 152: Second layer structure
- 153: Third layer structure
- 154: Flipped layer structure
- 155: Layer structure with two embedded conductive wiring structures
- 160: (First) conductive wiring structure
- 161: Second conductive wiring structure
- 162: Third conductive wiring structure
- 163: Fourth/surface conductive wiring structure
- 164: Embedded component
- 165: First lateral wall
- 166: Second lateral wall
- 167: Upper conductive wiring structure
- 168: Lower conductive wiring structure
- 170: Vertical connection through one layer
- 171: Vertical connection through two or more layers (further vertical connection)
- 172: First pillar
- 173: Second pillar
- 174: Stacked vias/pillars, further vertical connection
- 175: Vertical wiring connection (in bridge element)
- 180: Redistribution layer
- 190: Component carrier arrangement

## Claims

1. A component carrier (100) comprising:
a stack (101), comprising at least one electrically insulating layer structure (102) and at least one electrically conductive layer structure (104);
a bridge element (150) configured for connecting at least two components (110, 111) one to each other,
wherein the bridge element (150) comprises:
at least one layer structure (151) made of organic dielectric material, and
at least one conductive wiring structure (160) extending along a bridging direction,
wherein, along a cross-section perpendicular to the bridging direction, the at least one conductive wiring structure (160) comprises at least two lateral walls (165, 166), both inclined with respect to the stack thickness direction.

2. The component carrier (100) according to claim 1,
wherein the at least one conductive wiring structure (160) comprises a bottom portion and an upper portion connected by the two lateral walls (165, 166).

3. The component carrier (100) according to claim 1 or 2,
wherein the two lateral walls (165, 166) define a slanted shape toward to or away from the at least one layer structure (151).

4. The component carrier (100) according to one of the preceding claims,
wherein the bridge element (150) comprises at least one vertical connection (170), in particular a via or a pillar, extending from one main surface of the at least one layer structure (151) to the at least one conductive wiring structure (160).

5. The component carrier (100) according to one of the preceding claims,
wherein the bridge element (150) comprises a plurality of layer structures (151, 152, 153),
in particular with at least two, more in particular all, layer structures (151, 152, 153) of said plurality of layer structures made of organic dielectric material,
in particular
wherein at least two of the plurality of layers (151, 152, 153) comprise at least one respective conductive wiring structure (160, 161, 162) extending along the bridging direction,
wherein, in the cross-section perpendicular to the bridging direction, the at least one respective conductive wiring structure (160, 161, 162) comprises at least two lateral walls (165, 166), both inclined with respect to the stack thickness direction (z).

6. The component carrier (100) according to claim 5, further comprising:
at least one vertical wiring connection (175) connecting two conductive wiring structures (160, 161, 162) of two adjacent, in particular stacked, layer structures (151, 152, 153).

7. The component carrier (100) according to claim 5 or 6,
wherein at least one layer structure (154) is flipped with respect to the adjacent layer structure (152, 153),
in particular wherein two conductive wiring structures (160, 161) are exposed at the respective one of the two opposed main surfaces of the bridge element (150).

8. The component carrier (100) according to one of the preceding claims,
wherein at least one further vertical connection (171, 174) connects the two opposed main surfaces of the at least one layer structure (151), in particular the two opposed main surfaces of the bridge element (150).

9. The component carrier (100) according to one of the preceding claims,
wherein the at least one conductive wiring structure (160, 161, 162) comprises a surface on/flushing with one main surface of the at least one layer structure (151, 152, 153).

10. The component carrier (100) according to one of the preceding claims,
wherein the at least one electrically conductive layer structure (104) of the stack (101) is connected to the at least one vertical connection (170, 171) of the bridge element (150) by a connection structure,
in particular an intermediate material/structure (122, 123),
more in particular at least one of a nanostructure, a microstructure, nanowires, micro-vias, solder, Z-interconnection paste, a sintered material, an adhesive material.

11. The component carrier (100) according to one of the claims 5 to 10,
wherein the outermost layer structure (151) of the plurality of layer structures (151, 152, 153) comprises a different thickness, in particular is thinner, than one of the other layer structures (152, 153); and/or
wherein one of the conductive wiring structures (160, 161, 162) of the at least two of the plurality of layers (151, 152, 153) comprises a different thickness than the other conductive wiring structures (161, 162), in particular is thinner.

12. A component carrier arrangement (190), comprising:
a component carrier (100) according to one of the preceding claims; and
the at least two components (110, 111) assembled to the component carrier (100);
wherein the bridge element (150) connects the at least two components (110, 111) one to each other.

13. A method of manufacturing a component carrier (100), the method comprising:
providing a stack (101), comprising at least one electrically insulating layer structure (102) and at least one electrically conductive layer structure (104);
providing a bridge element (150),
wherein the bridge element (150) is for connecting at least two components (110, 111) one to each other,
wherein the bridge element (150) comprises at least one layer structure (151) made of organic dielectric material, and at least one conductive wiring structure (160) extending along a bridging direction, and
wherein, along a cross-section perpendicular to the bridging direction, the at least one conductive wiring structure (160) comprises at least one lateral wall (165, 166) inclined with respect to the stack thickness direction; and
assembling the bridge element (150) to the stack (101), in particular embedding the bridge element (150) in the stack (101).

14. The method according to claim 13, wherein providing the bridge element (150), in particular the conductive wiring structure (160), further comprises at least one of:
a nano imprint lithography, NIL, process; and/or
a reactive ion etching, RIE, process; and/or
a laser trench process.

15. The method according to claim 13 or 14, wherein embedding the bridge element (150) in the stack further comprises:
placing the bridge element (150) in a cavity of the stack (101);
in particular
removing material from the external surface, so that:
the external bridge element layer structure (151) comprises a different thickness than one or more other layer structures (152, 153), in particular is thinner; and/or
the external bridge element conductive wiring structure (160) comprises a different thickness than one or more other conductive wiring structures (161, 162), in particular is thinner; and/or
the external layers of the bridge element (150) and the stack (101), in particular also the dielectric encapsulation material, are flush;
more in particular
wherein the removing of material comprises grinding/routing,
in particular so that a constant scratching distribution is provided on the external layers of the bridge element (150) and the stack (101), in particular also the dielectric encapsulation material.
